# EUROPÄISCHE PATENTANMELDUNG

(11) **EP 3 432 436 A1**
(43) Veröffentlichungstag der Anmeldung: **23.01.2019**
(21) Anmeldenummer: 18183995.2
(22) Anmeldetag: 17.07.2018
(51) Int. Cl.: H02J 3/00, H02J 13/00, G01R 31/12

(54) **VERFAHREN UND SYSTEM ZUR ANPASSUNG DER ÜBERTRAGUNGSLEISTUNG VON STROMLEITUNGEN**

(30) Priorität: 17.07.2017 DE 102017116075
(71) Anmelder: Technische Universität Dortmund, 44227 Dortmund (DE)
(72) Erfinder: Dr. Kreischer, Christian, 22143 Hamburg (DE); Prof. Pfost, Martin, 44139 Dortmund (DE); Prof. Rehtanz, Christian, 44227 Dortmund (DE)
(74) Vertreter: Michalski Hüttermann & Partner Patentanwälte mbB

(57) **Zusammenfassung**

Bei einem Verfahren und einem System zur Anpassung der Übertragungsleistung von Stromleitungen (1), insbesondere von Hochspannungsfreileitungen, wird die Übertragungsleistung von Stromleitungen (1) dadurch erhöht, dass über einen an der Stromleitung (1) angeordneter und mit einem Datenverarbeitungssystem (4) verbundener Teilentladungssensor (2) die elektrische Teilentladungsaktivität der Stromleitung gemessen wird, im Datenverarbeitungssystem (4) mittels der gemessenen elektrischen Teilentladungsaktivität eine elektrische Belastbarkeit der Stromleitung (1) bestimmt wird, aus der elektrischen Belastbarkeit der Stromleitung (1) ein Sollwert für die maximale betriebliche Spannung der Stromleitung (1) bestimmt wird und die Übertragungsspannung der Stromleitung (1) entsprechend dem Sollwert angepasst wird.

## Beschreibung

Die vorliegende Erfindung betrifft ein Verfahren sowie ein System zur Anpassung der Übertragungsleistung von Stromleitungen.

Durch den massiven Ausbau der Energiegewinnung aus erneuerbaren Quellen sind die elektrischen Energieübertragungsnetze oft mehr als ausgelastet. Um in Engpasssituationen ein elektrisches Energieübertragungsnetz stabil, sicher und effizient zu betreiben, bietet es sich an, die Übertragungsleistung von wichtigen Übertragungsleitungen gezielt zu erhöhen. Eine bereits etablierte Möglichkeit hierzu ist eine witterungs- und temperaturabhängige Anpassung des zulässigen Leitungsstromes. Durch dieses unter der Bezeichnung thermisches Leiterseilmonitoring bekannte Verfahren lässt sich z.B. in Zeiträumen mit viel Wind ein möglichst großer Anteil von regenerativ erzeugter Energie abtransportieren. Hierbei wirkt sich eine größere Windgeschwindigkeit günstig auf die Kühlung der Freileitungen aus.

Aus der DE 10 2006 024 357 A1 sind ein Verfahren und Einrichtungen zur Bestimmung der elektrischen Belastbarkeit von Freileitungen mittels Temperaturmessung bekannt. Dazu wird über wenigstens einen an der Freileitung angeordnetem und mit einem Datenverarbeitungssystem verbundenen Sensor die Temperatur gemessen, die zeitabhängige Temperatur der Freileitung durch den vorhandenen oder einen gewichteten Belastungsparameter bestimmt und aus dem elektrischen Strom und der durch den Sensor gemessenen Temperatur unter Einbeziehung entweder des vorhandenen oder eines gewichteten Belastungsparameters eine zeitabhängige elektrische Belastung im Datenverarbeitungssystem ermittelt.

Aus der WO 99/60417 sind ein Verfahren sowie eine Vorrichtung zur Überprüfung von elektrischen Freileitungen bekannt, damit Fehlstellen ermittelt werden können. Das Verfahren besteht darin, elektromagnetische Signale in der Nähe der Freileitung über eine Antenne zu messen und aufzuzeichnen, wobei die aufgezeichneten Signale in mindestens zwei Frequenzbändern im Frequenz- und/oder im Zeitbereich analysiert werden. Neben der Aufzeichnung von elektromagnetischen Signalen werden synchron auch weitere Informationen wie Position, gesprochener Text, etc. aufgezeichnet.

Der Erfindung liegt die Aufgabe zugrunde, eine Lösung zu schaffen, die es ermöglicht, die Übertragungsleistung von Stromleitungen zu erhöhen.

Gelöst wird diese Aufgabe durch ein Verfahren und ein System gemäß den Patentansprüchen 1 und 9. Vorteilhafte Ausgestaltungen der Erfindung ergeben sich aus den Unteransprüchen sowie der nachfolgenden Beschreibung.

Bei einem Verfahren zur Anpassung der Übertragungsleistung von Stromleitungen, insbesondere von Hochspannungsfreileitungen, wird die Aufgabe erfindungsgemäß dadurch gelöst, dass über einen an der Stromleitung angeordneten und mit einem Datenverarbeitungssystem verbundenen Teilentladungssensor die elektrische Teilentladungsaktivität der Stromleitung gemessen wird, im Datenverarbeitungssystem mittels der gemessenen elektrischen Teilentladungsaktivität eine elektrische Belastbarkeit der Stromleitung bestimmt wird, aus der elektrischen Belastbarkeit der Stromleitung ein Sollwert für die maximale betriebliche Spannung der Stromleitung bestimmt wird und die Übertragungsspannung der Stromleitung entsprechend dem Sollwert angepasst wird.

Ein bisher ungenutzter Freiheitsgrad zur Anpassung der zulässigen Übertragungsleistung ist die Anpassung der zulässigen Übertragungsspannung. Zwar wurde im Laufe der Zeit die zulässige Spannung angehoben, beispielsweise von 380kV Nennspannung auf 420kV dauernd zulässiger Spannung im Übertragungsnetz, doch sind hier durch eine Messung der Teilentladungsaktivität weitere Optimierungspotentiale möglich.

Das erfindungsgemäße Verfahren ermöglicht es, die zulässige Übertragungsleistung durch Anpassung der zulässigen Übertragungsspannung zu erhöhen. Eine wichtige limitierende Größe für die Übertragungsspannung ist die Teilentladungseinsetzspannung. Die Teilentladungseinsetzspannung gibt an, ab welcher Spannung die Teilentladung einsetzt. Da durch Teilentladungen zusätzliche Verluste hervorgerufen werden, ist eine Überwachung der Teilentladungseinsetzspannung von Bedeutung. Die Teilentladungseinsetzspannung liegt beispielsweise für Hochspannungsfreileitungen mit Spannungen über 100kV noch unterhalb einer kritischen Überschlagsspannung, so dass eine gewisse Teilentladungsaktivität durchaus toleriert werden kann. Daher wird erfindungsgemäß die Teilentladungseinsetzspannung durch Messung der Teilentladungsaktivität mittels eines Teilentladungssensors gemessen. Erfindungsgemäß ist der Teilentladungssensor an der Stromleitung angeordnet, wodurch die Teilentladungsaktivität der Stromleitung genau gemessen werden kann.

Gemäß einer besonders bevorzugten Ausführungsform der Erfindung wird über einen an der Stromleitung angeordneten und mit dem Datenverarbeitungssystem verbundenen Witterungssensor die Witterungsbedingung am Ort des Witterungssensors gemessen wird, im Datenverarbeitungssystem mittels der gemessenen elektrischen Teilentladungsaktivität und der gemessenen Witterungsbedingung eine witterungsabhängige elektrische Belastbarkeit der Stromleitung bestimmt, aus der elektrischen Belastbarkeit der Stromleitung ein Sollwert für die maximale betriebliche Spannung der Stromleitung bestimmt wird und die Übertragungsspannung der Stromleitung entsprechend dem Sollwert angepasst wird.

Es ist bekannt, dass die Teilentladungsaktivität bestehender Hochspannungsfreileitungen bei feuchtem Wetter zunimmt und bei trockenem Wetter weniger stark ausgeprägt ist. Daher wird in einer bevorzugten Ausführungsform der Erfindung neben der Teilentladungsaktivität auch die Witterungsbedingung mittels eines Witterungssensors gemessen. Aus der gemessenen elektrischen Teilentladungsaktivität und der gemessenen Witterungsbedingung wird im Datenverarbeitungssystem eine witterungsabhängige elektrische Belastbarkeit der Stromleitung bestimmt. Aus der elektrischen Belastbarkeit der Stromleitung wird dann ein Sollwert für die maximale betriebliche Spannung der Stromleitung berechnet. Die Übertragungsspannung der Stromleitung wird entsprechend dem Sollwert angepasst, wobei bei geringer Teilentladungsaktivität die Spannung auf der Stromleitung erhöht und damit eine höhere Energiemenge über die Stromleitung geleitet werden kann. Daher sind bei einem witterungsabhängigen Betrieb weitere Optimierungspotentiale möglich.

Gemäß einer besonders bevorzugten Ausführungsform der Erfindung sind eine Mehrzahl von Teilentladungssensoren vorgesehen. Durch die Mehrzahl von Teilentladungssensoren kann die Teilentladungsaktivität genauer gemessen werden und es können Rückschlüsse auf den Entstehungsort der Teilentladung gezogen werden.

In einer weiteren bevorzugten Ausführungsform der Erfindung sind die Mehrzahl der Teilentladungssensoren entlang der Stromleitung verteilt. Durch die Verteilung der Teilentladungssensoren entlang der Stromleitung kann die Stromleitung über einen größeren Bereich überwacht und die Teilentladungsaktivität gemessen werden. Lokale Veränderungen der Teilentladungsaktivität können somit genauer bestimmt werden.

In einer bevorzugten Ausgestaltung der Erfindung sind eine Mehrzahl von Witterungssensoren vorgesehen. Durch eine Mehrzahl von Witterungssensoren kann die Witterungsbedingung genauer bestimmt werden.

Gemäß einer weiteren Ausgestaltung der Erfindung sind die Mehrzahl der Witterungssensoren entlang der Stromleitung verteilt. Die Verteilung der Witterungssensoren entlang der Stromleitung ist vorteilhaft, da die Witterungsbedingung nicht nur lokal, sondern entlang der Stromleitung gemessen werden kann. Auf lokale Veränderungen der Witterungsbedingung kann somit schnell reagiert werden.

In einer bevorzugten Ausführungsform der Erfindung erfolgt die Messung der elektrischen Teilentladungsaktivität mittels einer UHF-Teilentladungsmessung und der Teilentladungssensor ist ein UHF-Teilentladungssensor. Eine Begleiterscheinung der elektrischen Teilentladungsaktivität ist die Aussendung elektromagnetischer Wellen. Die Messung der elektromagnetischen Wellen im UHF-Frequenzbereich (Ultra High Frequency) liefert eine einfache und sichere Messung der Teilentladungsaktivität der Stromleitung.

Gemäß einer weiteren Ausgestaltung der Erfindung misst der Witterungssensor wenigstens die Luftfeuchtigkeit und/oder den Luftdruck am Ort des jeweiligen Witterungssensors. Es ist bekannt, dass die Teilentladungsaktivität bestehender Hochspanungsfreileitungen bei feuchtem Wetter zunimmt und bei trockenem Wetter weniger stark ausgeprägt ist. Eine Messung der Luftfeuchtigkeit durch den Witterungssensor ist daher besonders vorteilhaft. Neben der Luftfeuchtigkeit hat auch der Luftdruck einen Einfluss auf die Teilentladungsaktivität, wodurch auch die Messung des Luftdrucks vorteilhaft ist. Ebenso kann es vorgesehen sein, dass mittels des Witterungssensors weitere Meteorologische Größen wie beispielsweise Temperatur, Windrichtung und Windgeschwindigkeit gemessen wird.

Des Weiteren wird die obenstehende Aufgabe durch ein System zur Anpassung der Übertragungsleistung von Stromleitungen, insbesondere von Hochspannungsfreileitungen, erfindungsgemäß dadurch gelöst, dass ein an der Stromleitung angeordneter und mit einem Datenverarbeitungssystem verbundener Teilentladungssensor vorgesehen ist, der die elektrische Teilentladungsaktivität der Stromleitung misst, das Datenverarbeitungssystem der Art eingerichtet ist, mittels der gemessenen elektrischen Teilentladungsaktivität eine elektrische Belastbarkeit der Stromleitung zu bestimmen, um aus der elektrischen Belastbarkeit der Stromleitung ein Sollwert für die maximale betriebliche Spannung der Stromleitung zu bestimmen und die Übertragungsspannung der Stromleitung entsprechend dem Sollwert anzupassen.

Gemäß einer besonders bevorzugten Ausführungsform der Erfindung ist ein an der Stromleitung angeordneter und mit dem Datenverarbeitungssystem verbundener Witterungssensor vorgesehen ist, der die Witterungsbedingung am Ort des Witterungssensors misst, das Datenverarbeitungssystem der Art eingerichtet ist, mittels der gemessenen elektrischen Teilentladungsaktivität und der gemessenen Witterungsbedingung eine witterungsabhängige elektrische Belastbarkeit der Stromleitung zu bestimmen, um aus der elektrischen Belastbarkeit der Stromleitung ein Sollwert für die maximale betriebliche Spannung der Stromleitung zu bestimmen und die Übertragungsspannung der Stromleitung entsprechend dem Sollwert anzupassen.

Gemäß einer besonders bevorzugten Ausführungsform der Erfindung sind eine Mehrzahl von Teilentladungssensoren vorgesehen.

In einer weiteren bevorzugten Ausführungsform der Erfindung sind die Mehrzahl der Teilentladungssensoren entlang der Stromleitung verteilt.

Weiter bevorzugt sind eine Mehrzahl von Witterungssensoren vorgesehen.

In eine bevorzugten Ausführungsform der Erfindung sind die Mehrzahl der Witterungssensoren entlang der Stromleitung verteilt.

In eine weiteren bevorzugten Ausführungsform der Erfindung ist der Teilentladungssensor ein UHF-Teilentladungssensor.

Weiter bevorzugt ist der Witterungssensor wenigstens zur Messung der Luftfeuchtigkeit und/oder des Luftdrucks am Ort des jeweiligen Witterungssensors eingerichtet.

Die Erfindung wird nachfolgen anhand einer Figur weiter erläutert.

Es zeigt:

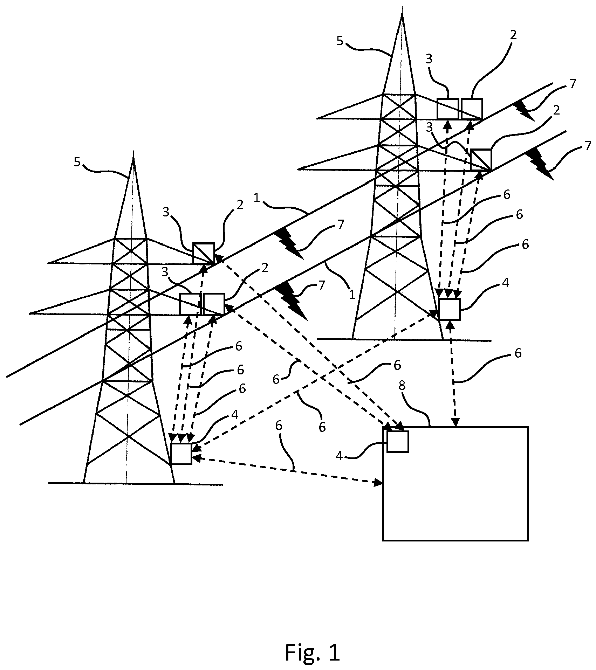

- Fig. 1: eine schematische Darstellung eines Systems zur Durchführung eines Verfahrens zur Anpassung der Übertragungsleistung von Stromleitungen gemäß einem bevorzugten Ausführungsbeispiel der Erfindung.

Das System zur Durchführung eines Verfahrens zur Anpassung der Übertragungsleistung von Stromleitungen 1 gemäß einem bevorzugten Ausführungsbeispiel der Erfindung besteht im Wesentlichen aus einem Teilentladungssensor 2, einem Witterungssensor 3 und einem Datenverarbeitungssystem 4. Der Teilentladungssensor 2 und der Witterungssensor 3 sind dabei an der Stromleitung 1 angeordnet. Der Teilentladungssensor 2 sowie der Witterungssensor 3 können einzeln oder als ein gemeinsames Sensorsystem an der Stromleitung 1 angeordnet sein. Der Teilentladungssensor 2 sowie der Witterungssensor 3 können dabei direkt an der Stromleitung angebracht sein oder in einer bevorzugten Ausführung beispielsweise an einem Hochspannungsmast befestigt sein.

In einer weiteren Ausgestaltung der Erfindung ist der Teilentladungssensor 2 ein UHF Teilentladungssensor. Die von der Teilentladung 7 im ultrahochfrequenten Bereich abgestrahlten elektromagnetischen Wellen werden von dem Teilentladungssensor 2 detektiert, wodurch sich die Teilentladungsaktivität der Stromleitung 1 jederzeit genau berechnen lässt. Weiter bevorzugt sind mehrere Teilentladungssensoren 2 und mehrere Witterungssensoren 3 vorgesehen, die entlang der Stromleitung 1 verteilt angebracht sind. Durch die Verteilung der Teilentladungssensoren 2 und Witterungssensoren 3 können die Teilentladungsaktivität sowie die Witterungsbedingung nicht nur lokal, sondern über einen größeren Bereich entlang der Stromleitung 1 gemessen werden.

Vorteilhaft dabei ist, dass der Witterungssensor 3 wenigstens die Luftfeuchtigkeit und/oder den Luftdruck am Ort des jeweiligen Witterungssensors misst. Da die Teilentladungsaktivität von Hochspanungsfreileitungen bei feuchtem Wetter zunimmt und bei trockenem Wetter weniger stark ausgeprägt ist und auch der Luftdruck einen Einfluss auf die Teilentladungsaktivität hat, ist eine Messung der Luftfeuchtigkeit sowie des Luftdrucks besonders vorteilhaft. Beispielsweise ergibt sich für ein Mastbild einer 100kV-Leitung mit r=0,785cm und d=327cm bei normalem Luftdruck eine witterungsabhängige kritische Spannung (erstmaliges Einsetzen von Koronaerscheinungen) zwischen 120kV und 148kV (23% Schwankungsbreite). Eine niedrigere Spannung stellt sich bei schlechtem Wetter mit Nebel, Schnee und Regen ein, während die obere Spannungsgrenze bei schönem Wetter erreicht wird. Bei einer 110kV-Leitung beträgt zum Vergleich die derzeit maximal zulässige Spannung für die Betriebsmittel 123kV. Eine 220kV-Leitung darf beispielsweise unter Berücksichtigung von Koronaverlusten bis zu 245kV betrieben werden. Bei schönem Wetter ergeben sich für 245kV mittlere Koronaverluste von 0,3kW/km, während bei den ungünstigsten Bedingungen Koronaverluste von ca. 20kW/km anfallen.

Die Daten der Teilentladungssensoren 2 sowie der Witterungssensoren 3 werden über eine Datenverbindung 6 an das Datenverarbeitungssystem 4 übermittelt und ausgewertet. Die Übertragung der Daten mittels der Datenverbindung 6 kann dabei über Funk, Kabel oder einer weiteren Netzwerktechnologie erfolgen. Das Datenverarbeitungssystem 4 kann dabei direkt am Hochspannungsmast 5 der Stromleitung 1 angeordnet. Im Datenverarbeitungssystem 4 wird mittels der gemessenen elektrischen Teilentladungsaktivität und der gemessenen Witterungsbedingung eine witterungsabhängige elektrische Belastbarkeit der Stromleitung 1 bestimmt. Aus der elektrischen Belastbarkeit der Stromleitung 1 wird weiter ein Sollwert für die maximale betriebliche Spannung der Stromleitung 1 bestimmt. Die ausgewerteten Daten werden anschließend an die Schaltzentrale 8 des elektrischen Energieübertragungsnetzes weitergeleitet und die Übertragungsspannung der Stromleitung 1 entsprechend dem Sollwert angepasst. Für schlechte Witterungsverhältnisse und schwacher Netzauslastung kann es demnach durchaus sinnvoll sein, das Spannungsniveau zu reduzieren und den Leitungsstrom zu erhöhen, um die Koronaverluste in Grenzen zu halten. Umgekehrt kann bei schönem Wetter die Netzspannung unter vertretbaren Koronaverlusten erhöht werden.

In einer Ausführungsform der Erfindung kann es auch vorgesehen sein, dass sich das Datenverarbeitungssystem 4 in der Schaltzentrale 8 befindet und die Daten der Teilentladungssensoren 2 sowie der Witterungssensoren 3 mittels einer Datenverbindung 6 direkt an das Datenverarbeitungssystem 4 in der Schaltzentrale 8 übermittelt werden. Weiter kann vorgesehen sein, dass die Teilentladungssensoren 2, die Witterungssensoren 3 sowie das Datenverarbeitungssystem 4 autark, beispielsweise solarbetrieben und akkugepuffert, betrieben werden.

### Bezugszeichenliste

- 1: Stromleitung
- 2: Teilentladungssensor
- 3: Witterungssensor
- 4: Datenverarbeitungssystem
- 5: Hochspannungsmast
- 6: Datenverbindung
- 7: Teilentladung
- 8: Schaltzentrale

## Patentansprüche

1. Verfahren zur Anpassung der Übertragungsleistung von Stromleitungen (1), insbesondere von Hochspannungsfreileitungen, **dadurch gekennzeichnet, dass**
über einen an der Stromleitung (1) angeordneten und mit einem Datenverarbeitungssystem (4) verbundenen Teilentladungssensor (2) die elektrische Teilentladungsaktivität der Stromleitung (1) gemessen wird,
im Datenverarbeitungssystem (4) mittels der gemessenen elektrischen Teilentladungsaktivität eine elektrische Belastbarkeit der Stromleitung (1) bestimmt wird,
aus der elektrischen Belastbarkeit der Stromleitung (1) ein Sollwert für die maximale betriebliche Spannung der Stromleitung (1) bestimmt wird und
die Übertragungsspannung der Stromleitung (1) entsprechend dem Sollwert angepasst wird.

2. Verfahren nach Anspruch 1 **dadurch gekennzeichnet, dass** über einen an der Stromleitung (1) angeordneten und mit dem Datenverarbeitungssystem (4) verbundenen Witterungssensor (3) die Witterungsbedingung am Ort des Witterungssensors (3) gemessen wird,
im Datenverarbeitungssystem (4) mittels der gemessenen elektrischen Teilentladungsaktivität und der gemessenen Witterungsbedingung eine witterungsabhängige elektrische Belastbarkeit der Stromleitung (1) bestimmt wird,
aus der elektrischen Belastbarkeit der Stromleitung (1) ein Sollwert für die maximale betriebliche Spannung der Stromleitung (1) bestimmt wird und
die Übertragungsspannung der Stromleitung (1) entsprechend dem Sollwert angepasst wird.

3. Verfahren nach einem der vorherigen Ansprüche **dadurch gekennzeichnet, dass** eine Mehrzahl von Teilentladungssensoren (2) vorgesehen sind.

4. Verfahren nach Anspruch 3 **dadurch gekennzeichnet, dass** die Mehrzahl der Teilentladungssensoren entlang der Stromleitung (1) verteilt sind.

5. Verfahren nach einem der Ansprüche 2 bis 4 **dadurch gekennzeichnet, dass** eine Mehrzahl von Witterungssensoren (3) vorgesehen sind.

6. Verfahren nach Anspruch 5 **dadurch gekennzeichnet, dass** die Mehrzahl der Witterungssensoren (4) entlang der Stromleitung (1) verteilt sind.

7. Verfahren nach einem der vorherigen Ansprüche **dadurch gekennzeichnet, dass** die Messung der elektrischen Teilentladungsaktivität mittels einer UHF-Teilentladungsmessung erfolgt und der Teilentladungssensor (2) ein UHF-Teilentladungssensor ist.

8. Verfahren nach einem der Ansprüche 2 bis 7 **dadurch gekennzeichnet, dass** der Witterungssensor (3) wenigstens die Luftfeuchtigkeit und/oder den Luftdruck am Ort des jeweiligen Witterungssensors (3) misst.

9. System zur Anpassung der Übertragungsleistung von Stromleitungen (1), insbesondere von Hochspannungsfreileitungen, **dadurch gekennzeichnet, dass**
ein an der Stromleitung (1) angeordneter und mit einem Datenverarbeitungssystem (4) verbundener Teilentladungssensor (2) vorgesehen ist, der die elektrische Teilentladungsaktivität der Stromleitung (1) misst,
das Datenverarbeitungssystem (4) der Art eingerichtet ist, mittels der gemessenen elektrischen Teilentladungsaktivität eine elektrische Belastbarkeit der Stromleitung (1) zu bestimmen, um aus der elektrischen Belastbarkeit der Stromleitung (1) ein Sollwert für die maximale betriebliche Spannung der Stromleitung (1) zu bestimmen und die Übertragungsspannung der Stromleitung (1) entsprechend dem Sollwert anzupassen.

10. System nach Anspruch 9 **dadurch gekennzeichnet, dass** ein an der Stromleitung (1) angeordneter und mit dem Datenverarbeitungssystem (4) verbundener Witterungssensor (3) vorgesehen ist, der die Witterungsbedingung am Ort des Witterungssensors (3) misst,
das Datenverarbeitungssystem (4) der Art eingerichtet ist, mittels der gemessenen elektrischen Teilentladungsaktivität und der gemessenen Witterungsbedingung eine witterungsabhängige elektrische Belastbarkeit der Stromleitung (1) zu bestimmen, um aus der elektrischen Belastbarkeit der Stromleitung (1) ein Sollwert für die maximale betriebliche Spannung der Stromleitung (1) zu bestimmen und die Übertragungsspannung der Stromleitung (1) entsprechend dem Sollwert anzupassen.

11. System nach einem der Ansprüche 9 bis 10 **dadurch gekennzeichnet, dass** eine Mehrzahl von Teilentladungssensoren (2) vorgesehen ist.

12. System nach einem der Ansprüche 9 bis 11**dadurch gekennzeichnet, dass** die Mehrzahl der Teilentladungssensoren (2) entlang der Stromleitung (1) verteilt sind.

13. System nach einem der Ansprüche 8 bis 12 **dadurch gekennzeichnet, dass** eine Mehrzahl von Witterungssensoren (3) vorgesehen ist.

14. System nach Anspruch 13 **dadurch gekennzeichnet, dass** die Mehrzahl der Witterungssensoren (3) entlang der Stromleitung (1) verteilt sind.

15. System nach einem der vorherigen Ansprüche 8 bis 14 **dadurch gekennzeichnet, dass** der Teilentladungssensor (2) ein UHF-Teilentladungssensor ist.

16. System nach einem der Ansprüche 8 bis 15 **dadurch gekennzeichnet, dass** der Witterungssensor (3) wenigstens zur Messung der Luftfeuchtigkeit und/oder des Luftdrucks am Ort des jeweiligen Witterungssensors (3) eingerichtet ist.
